# EUROPEAN PATENT APPLICATION

(11) **EP 4 738 759 A1**
(43) Date of publication of application: **06.05.2026**
(21) Application number: 25191253.1
(22) Date of filing: 23.07.2025
(51) Int. Cl.: H04L 7/00, G11C 7/22, H03L 7/00, H03L 7/093

(54) **PHASE DETECTION DEVICE AND METHOD FOR DETECTING PHASE**

(30) Priority: 30.10.2024 KR 20240150932
(71) Applicant: Samsung Electronics Co., Ltd., Suwon-si, Gyeonggi-do 16677 (KR)
(72) Inventor: JUNG, Jinook, 16677 Suwon-si, Gyeonggi-do (KR); PARK, Jaewoo, 16677 Suwon-si, Gyeonggi-do (KR); KWAK, Myoungbo, 16677 Suwon-si, Gyeonggi-do (KR); BAEK, Seungyeob, 16677 Suwon-si, Gyeonggi-do (KR)
(74) Representative: Kuhnen & Wacker Patent- und Rechtsanwaltsbüro PartG mbB

(57) **Abstract**

A receiver (RX) includes an analog front end (510) configured to receive a data input/output signal (DQ) and amplify the data input/output signal (DQ) and generate a processing signal (DQE), a time interleaved analog-to-digital converter (TI ADC 520) configured to sample the processing signal (DQE) and generate a plurality of digital data signals (DO), a Mueller-Muller phase detector (530) configured to receive the digital data signals (DO) and drive at least one of a plurality of calculators based on a transition between two digital data signals (DO), a monitoring circuit (570) configured to receive the digital data signals (DO), receive a multi-level signal (MS) transmitted from a transmitter (TX), and generate a monitoring output signal (MV) based on the digital data signals (DO) and the multi-level signal (MS), and a control logic circuit (580) configured to receive a monitoring output signal (MV) and generate a plurality of calculator selection signals (CAL_EN) for driving the calculators based on the monitoring output signal (MV).

## Description

### BACKGROUND

Although electronic devices operate internally through digital signal processing, their interfaces with external devices primarily rely on analog signal transmission. As performance of electronic devices improves, communication frequencies are becoming higher and higher, and as communication frequencies increase, an effect of jitter in signals received from external devices may become more noticeable. The effect of jitter may cause timing mismatch when a receiver samples an analog signal digitally. Timing instability may cause bit errors and sampling distortion during signal conversion. Accordingly, the integrity of the analog signal received by the receiver from the external device may be damaged.

### SUMMARY

In general, the present disclosure is directed toward a phase detection device and a phase detection method capable of being driven by low electric power.

According to some implementations, the present disclosure is directed to a phase detection device and a phase detection method capable of precisely detecting a phase difference between a data signal and a clock signal.

According to some implementations, the present disclosure is directed to a receiver that includes an analog front end configured to receive a data input/output signal, and amplify the data input/output signal, to generate a processing signal, a time interleaved analog-to-digital converter (TI ADC) configured to sample the processing signal based on a plurality of clock signals and generate a plurality of digital data signals, a Mueller-Muller phase detector configured to receive the digital data signals from the time interleaved analog-to-digital converter and drive at least one of a plurality of calculators based on a transition between two digital data signals received sequentially among the digital data signals, a monitoring circuit configured to receive the digital data signals from the time interleaved analog-to-digital converter, receive a multi-level signal transmitted from a transmitter, and generate a monitoring output signal based on the digital data signals and the multi-level signal, and a control logic configured to receive a monitoring output signal output from the monitoring circuit and generate a plurality of calculator selection signals for driving the calculators based on the monitoring output signal.

According to some implementations, the present disclosure is directed to a phase detection device that includes a plurality of calculators configured to output a plurality of sampling control signals corresponding to transitions of two adjacent digital data signals and controlling sampling timing for sampling the signals, a monitoring circuit configured to obtain the digital data signal, receive a multi-level signal having one of *N* signal levels (*N* is a positive number) from a transmitter, and generate a monitoring output signal using the digital data signal and the multi-level signal, a control logic configured to compare the monitoring output signal with a first reference value and generate a plurality of calculator selection signals that drive the calculators, and a plurality of switches configured to transfer a driving voltage from a voltage source to the calculators based on the calculator selection signals.

According to some implementations, the present disclosure is directed to a phase detection method that includes computing a bit error rate based on a multi-level signal having one of *N* (*N* is a positive number) signal levels received from a transmitter and a digital data signal obtained from a time interleaved analog-to-digital converter, comparing the computed bit error rate with a first reference value and generating a plurality of calculator selection signals for turning on or off a plurality of switches respectively connected between a plurality of calculators and a voltage source based on a compared result value thereof, and supplying the calculator selection signals to the switches and the multiplexers that receive sampling control signals output from the calculators.

### BRIEF DESCRIPTION OF THE DRAWINGS

Example implementations will be more clearly understood from the following detailed description, taken in conjunction with the accompanying drawings.
FIG. 1 illustrates a block diagram of an example of a memory system according to some implementations.
FIG. 2 illustrates a block diagram showing an example of a memory device according to some implementations.
FIGS. 3 and 4 illustrate block diagrams showing examples of a transmitter and a receiver included in each of a memory controller and a memory device according to some implementations.
FIG. 5 illustrates a block diagram showing an example of a data transmitting/receiving system according to some implementations.
FIG. 6 illustrates a graph showing an example of a processing signal according to some implementations.
FIG. 7 illustrates a circuit diagram of an example of a time interleaved analog-to-digital converter according to some implementations.
FIG. 8 illustrates a graph showing an example of a process in which a processing signal is converted into digital data through an analog-to-digital converter according to some implementations.
FIG. 9 illustrates a block diagram showing an example of a portion of a configuration of a Mueller-Muller phase detector according to some implementations.
FIG. 10 illustrates a flowchart showing an example of a process in which an operator and a multiplexer are driven by an operator selection signal according to some implementations.
FIG. 11 illustrates a table showing examples of gain and current consumption generated in a Mueller-Muller phase detector based on transition of digital data according to some implementations.
FIG. 12 illustrates an example block diagram showing an example of a computer device according to some implementations.

### DETAILED DESCRIPTION

The present disclosure will be described more fully hereinafter with reference to the accompanying drawings, in which embodiments of the present disclosure are shown.

Accordingly, the drawings and description are to be regarded as illustrative in nature and not restrictive. Like reference numerals designate like elements throughout the specification. In a flowchart described with reference to the drawings, an order of operations may be changed, several operations may be merged, some operations may be divided, and specific operations may not be performed.

In addition, expressions written in the singular may be construed in the singular or plural unless an explicit expression such as "one" or "single" is used. Terms including ordinal numbers such as first, second, and the like will be used only to describe various component and are not to be interpreted as limiting these components. These terms may be used for the purpose of distinguishing one constituent element from other constituent elements.

Hereinafter, the present disclosure will be described in more detail through examples. These examples are merely for illustrating the present disclosure, and the scope of right protection of the present disclosure is not limited by these examples.

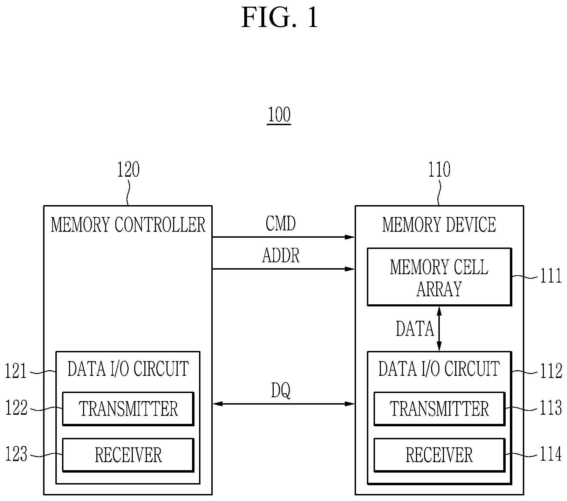

FIG. 1 illustrates a block diagram of an example of a memory system according to some implementations. In FIG. 1, a memory system 100 may include a memory device 110 and a memory controller 120. In some implementations, the memory device 110 and the memory controller 120 may be connected through a memory interface to transmit and receive signals through a memory interface.

The memory device 110 includes a memory cell array 111 and a data I/O circuit 112. The memory cell array 111 includes a plurality of memory cells connected to a plurality of rows and a plurality of columns. In some implementations, rows may be defined by wordlines and columns may be defined by bitlines. The data I/O circuit 112 may store data transferred from the outside in the memory cell array 111, or may output data stored in the memory cell array 111 to the outside of the memory device 110 (i.e., the memory controller 120, etc.).

The data I/O circuit 112 may include a transmitter 113 and a receiver 114. The transmitter 113 may receive data DATA from the memory cell array 111 to encode it, and may output a data input/output signal DQ based on the encoded signal. In some implementations, a multi-symbol (or multi-level) modulation scheme may be used to modulate a signal communicated between the memory controller 120 and the memory device 110. Examples of multi-symbol modulation schemes include, but are not limited to, pulse amplitude modulation (PAM), quadrature amplitude modulation (QAM), quadrature phase shift keying (QPSK), and/or the like. A multi-symbol signal may be a signal modulated by using a modulation scheme including at least three levels to encode more than one bit of information. Multi-symbol modulation schemes and symbols may alternatively be referred to as non-binary, multi-bit, or higher order modulation schemes and symbols. For example, the transmitter 113 may generate and output a data input/output signal (DQ) capable of expressing 2a (=n) data values, including a symbol of a number of bits according to n-level pulse amplitude modulation (PAM-n). The transmitter 113 may generate and output the data input/output signal (DQ) capable of expressing four data values (00, 01, 10, and 11) including a 2-bit number of symbols depending on PAM-4. Hereinafter, it is assumed that the data I/O circuit 112 uses a PAM-4 scheme.

The receiver 114 may receive the data input/output signal (DQ) supplied from the memory controller 120, and may decode the received DQ to generate PAM-4 data. The PAM-4 data may include digital data that can represent four data values (00, 01, 10, and 11). An operation process of the receiver 114 will be described in detail below.

The memory controller 120 controls a memory operation of the memory device 110 by providing a signal to the memory device 110. The signal may include a command CMD and an address ADDR. In some implementations, the memory controller 120 may provide the command CMD and the address ADDR to the memory device 110 to access the memory cell array 111 and control a memory operation such as reading or writing. According to the reading operation, the data input/output signal (DQ) may be transferred from the memory cell array 111 to the memory controller 120, and according to a writing operation, the data input/output signal (DQ) may be transferred from the memory controller 120 to the memory cell array 111.

The memory device 110 and the memory controller 120 may mutually transmit and receive the data input/output signal (DQ) in a serial interfacing manner. The memory controller 120 may access the memory device 110 depending on a request from a host outside the memory system 100. The memory controller 120 may communicate with the host by using various protocols. For example, the memory controller 120 may communicate with an external host in a parallel interfacing manner. In some implementations, the memory controller 120 may communicate with the host in a serial interfacing manner.

The command CMD may include an activation command, a reading/writing command, and a refresh command. The activation command may be a command for converting a target row of the memory cell array 111 to an active state in order to write data to or read data from the memory cell array 111. A memory cell of the target row may be activated (e.g., driven) in response to the activation command. The reading/writing command may be a command for performing a reading or writing operation on a target memory cell of a row switched to an active state. The refresh command may be a command for performing a refresh operation in the memory cell array 111.

When the command CMD is the reading command, the transmitter 113 may receive the data DATA from the memory cell array 111. The transmitter 113 may encode data DATA based on the PAM-4, and may output the encoded signal as the data input/output signal (DQ).

The data I/O circuit 121 of the memory controller 120 may output data as the data input/output signal (DQ) to the memory device 110, or may receive the data input/output signal (DQ) outputted from the memory device 110. The data I/O circuit 121 may include a transmitter 122 and a receiver 123. The transmitter 122 may transmit data provided from an external host to the memory device 110. The transmitter 122 and the receiver 123 of the memory controller 120 may be substantially the same as the transmitter 113 and the receiver 114 of the memory device 110, so reference is made to the above description of the transmitter 113 and the receiver 114 of the memory device 110.

The memory device 110 may be a storage device based on a semiconductor device. In some embodiments, the memory device 110 may include a dynamic random access memory (DRAM) device. In some implementations, the memory device 110 may include another volatile or non-volatile memory device in which the transmitter 113 or the receiver 114 is used.

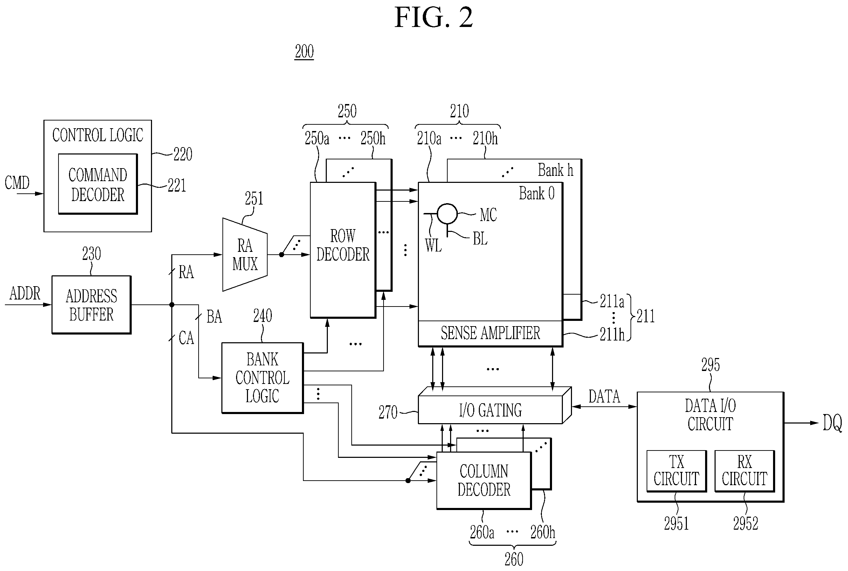

FIG. 2 illustrates a block diagram showing an example of a memory device according to some implementations. In FIG. 2, a memory device 200 may include a memory cell array 210, a sense amplifier 211, a control logic circuit 220, an address buffer 230, a row decoder 250, a column decoder 260, an I/O gating circuit 270, and a data I/O circuit 295.

The memory cell array 210 may include a plurality of memory cells MC. In some implementations, the memory cell array 210 may include a plurality of memory banks 210a to 210h. Although eight memory banks BANK0 to BANKh 210a to 210h are illustrated in FIG. 2, the number of memory banks is not limited thereto. Each of the memory banks 210a to 210h may include a plurality of rows, a plurality of columns, and a plurality of memory cells MC arranged at intersections of the rows and the columns. In some implementations, the rows may be defined by a plurality of word lines WL, and the columns may be defined by a plurality of bit lines BL.

The control logic circuit 220 may control an operation of the memory device 200. For example, the control logic circuit 220 may generate a control signal such that the memory device 200 performs a reading operation, a writing operation, an offset calibration operation, and the like. In some implementations, the control logic circuit 220 may include a command decoder 221. The command decoder 221 may generate a control signal by decoding the command CMD received from the memory controller (e.g., 120 of FIG. 1).

The address buffer 230 receives the address ADDR provided from the memory controller 120. The address ADDR includes a row address RA indicating a row of the memory cell array 210 and a column address CA indicating a column thereof. The row address RA is provided to the row decoder 250, and the column address CAis provided to the column decoder 260. In some implementations, the memory device 200 may further include a row address multiplexer 251. The row address RA may be provided to the row decoder 250 through the row address multiplexer 251. In some implementations, the address ADDR may further include a bank address BA indicating a memory bank. The bank address BA may be provided to the bank control logic 240.

In some implementations, the memory device 200 may further include a bank control logic 240 that generates a bank control signal in response to the bank address BA. The bank control logic 240 may activate the row decoder 250 corresponding to the bank address BA among a plurality of row decoders 250 in response to the bank control signal, and may activate the column decoder 260 corresponding to the bank address BA among a plurality of column decoders 260.

The row decoder 250 selects a row to be activated from among a plurality of rows of the memory cell array 210 based on the row address. To this end, the row decoder 250 may apply a driving voltage to a word line corresponding to the row to be activated. In some implementations, the row decoders 250a to 250h corresponding to the respective memory banks 210a to 210h may be provided.

The column decoder 260 selects a column to be activated from among a plurality of columns of the memory cell array 210 based on the column address. To this end, the column decoder 260 may activate the sense amplifier 211 corresponding to the column address CA through the I/O gating circuit 270. In some implementations, column decoders 260a to 260h corresponding to the respective memory banks 210a to 210h may be provided. In some implementations, the I/O gating circuit 270 may gate input/output data, and may include a data latch for storing data read from the memory cell array 210 and a write driver for writing data to the memory cell array 210. Data read from the memory cell array 210 may be sensed by the sense amplifier 211, and may be stored in the I/O gating circuit 270 (e.g., a data latch). In some implementations, a plurality of sense amplifiers 211a to 211h corresponding to the respective memory banks 210a to 210h may be provided.

In some implementations, data read from the memory cell array 210 (e.g., data stored in a data latch) may be provided to the memory controller 120 through the data I/O circuit 295. Data to be written into the memory cell array 210 may be provided from the memory controller 120 to the data I/O circuit 295, and data provided to the data I/O circuit 295 may be provided to the I/O gating circuit 270.

The data I/O circuit 295 may output the data input/output signal (DQ) or receive the data input/output signal (DQ). The data I/O circuit 295 may include a TX CIRCUIT (hereinafter referred to as a 'transmitter') 2951 and a RX CIRCUIT (hereinafter referred to as a 'receiver') 2952. The transmitter 2951 may encode the data DATA transmitted from the I/O gating circuit 270 based on the PAM-4 to output it as the data input/output signal (DQ). The receiver 2952 may decode the received data input/output signal (DQ), may restore it as a PAM-4 signal, and may transfer the data DATA based on the restored signal to the I/O gating circuit 270.

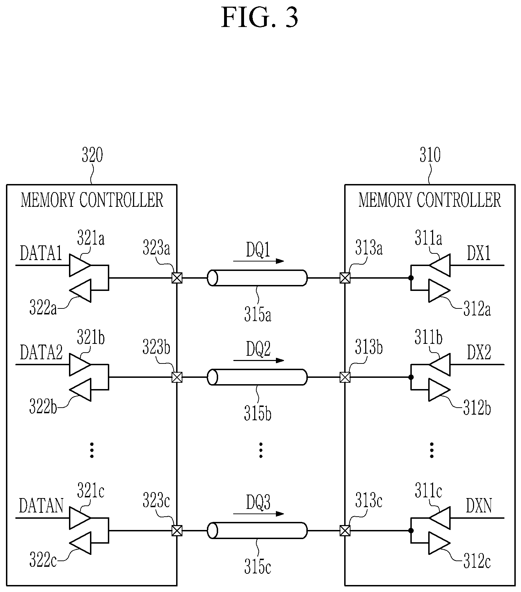

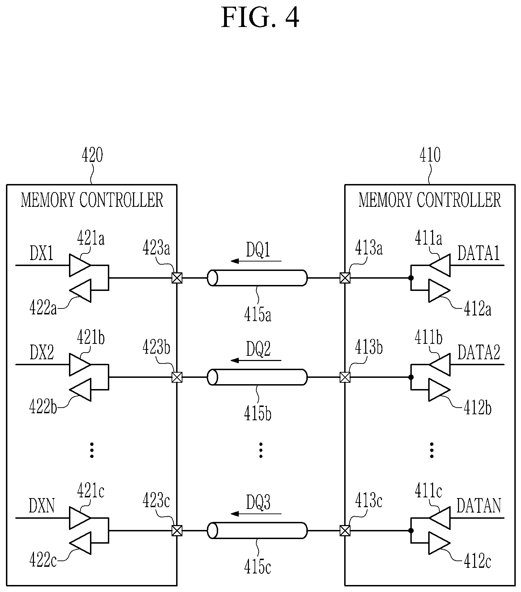

FIGS. 3 and 4 illustrate block diagrams showing examples of a transmitter and a receiver included in each of a memory controller and a memory device according to some implementations. In FIGS. 3 and 4, the memory system 100 (in FIG. 1) may include a semiconductor memory device 310, a memory controller 320, and a plurality of channels 315a, 315b, and 315c.

The semiconductor memory device 310 may include a plurality of transmitters 311a, 311b, and 311c, a plurality of receivers 312a, 312b, and 312c, and a plurality of data input/output pads 313a, 313b, and 313c. The memory controller 320 may include a plurality of transmitters 321a, 321b, and 321c, a plurality of receivers 322a, 322b, and 322c, and a plurality of data input/output pads 323a, 323b, and 323c.

Each of the transmitters 311a, 311b, 311c, 321a, 321b, and 321c may generate the data input/output signal (DQ), which is a multi-level data signal. Each of the receivers 312a, 312b, 312c, 322a, 322b, and 322c may receive the data input/output signal (DQ). The transmitters 311a, 311b, 311c, 321a, 321b, and 321c and the receivers 312a, 312b, 312c, 322a, 322b, and 322c may transmit data input/output signals (DQ) through a plurality of channels 315a, 315b, and 315c.

Each of the data input/output pads 313a, 313b, 313c, 323a, 323b, and 323c may be connected to one of the transmitters 311a, 311b, 311c, 321a, 321b, and 321c and one of the receivers 312a, 312b, 312c, 322a, 322b, and 322c.

The channels 315a, 315b, and 315c may connect the memory controller 320 and the semiconductor memory device 310. Each of the channels 315a, 315b, and 315c may be connected to one of the transmitters 321a, 321b, and 321c and one of the receivers 322a, 322b, and 322c through one of the data input/output pads 323a, 323b, and 323c. Each of the channels 315a, 315b, and 315c may be connected to one of the transmitters 311a, 311b, and 311c and one of the receivers 312a, 312b, and 312c through one of the data input/output pads 313a, 313b, and 313c. The data input/output signal (DQ) may be transmitted through each of the channels 315a, 315b, and 315c.

FIG. 3 illustrates an operation of transmitting data from the memory controller 320 to the semiconductor memory device 310. For example, the transmitter 321a may generate a data input/output signal DQ1, which is a multi-level data signal, based on input data DATA1. The output data input signal DQ1 may be transmitted from the memory controller 320 to the semiconductor memory device 310 through the channel 315a. The receiver 312a may receive the data input/output signal DQ1 to obtain target data DX1 corresponding to the input data DATA1.

Similarly, the transmitter 321b may generate a data input/output signal DQ2, which is a multi-level data signal, based on input data DATA2. The data input/output signal DQ2 may be transmitted to the semiconductor memory device 310 through the channel 315b. The receiver 312b may receive the data input/output signal DQ2 to obtain target data DX2 corresponding to the input data DATA2.

Similarly, the transmitter 321c may generate a data input/output signal DQ3, which is a multi-level data based on input data DATAN. The data input/output signal DQ3 may be transmitted to the semiconductor memory device 310 through the channel 315c. The receiver 312c may receive the data input/output signal DQ3 to obtain target data DXN to the input data DATAN.

FIG. 4 illustrates an operation of transmitting data from a semiconductor memory device 410 to a memory controller 420. Similarly, the transmitter 411a may generate a data input/output signal DQ1, which is the multi-level data based on the input data DATA1. The data input/output signal DQ1 may be transmitted from the semiconductor memory device 410 to the memory controller 420 through a channel 415a. The receiver 422a may receive the data input/output signal DQ1 to obtain target data DX1 corresponding to the input data DATA1.

Similarly, the transmitter 411b may generate a data input/output signal DQ2, which is a multi-level data signal, based on input data DATA2. The data input/output signal DQ2 may be transmitted to the memory controller 420 through the channel 415b. The receiver 422b may receive the data input/output signal DQ2 to obtain target data DX2 corresponding to the input data DATA2. Similarly, the transmitter 411c may generate a data input/output signal DQ3, which is a multi-level data based on input data DATAN. The data input/output signal DQ3 may be transmitted to the memory controller 420 through the channel 415c. The receiver 422c may receive the data input/output signal DQ3 to obtain data DXN to the input data DATAN. In this case, the input data DATA1, DATA2, and DATAN may be read data read from the semiconductor memory device 410.

Hereinafter, better understanding and ease of description, operations of the transmitters 321a, 321b, and 321c of the memory controller 320 and the receivers 312a, 312b, and 312c of the semiconductor memory device 310 when transmitting data from the memory controller 320 to the semiconductor memory device 310 will be described.

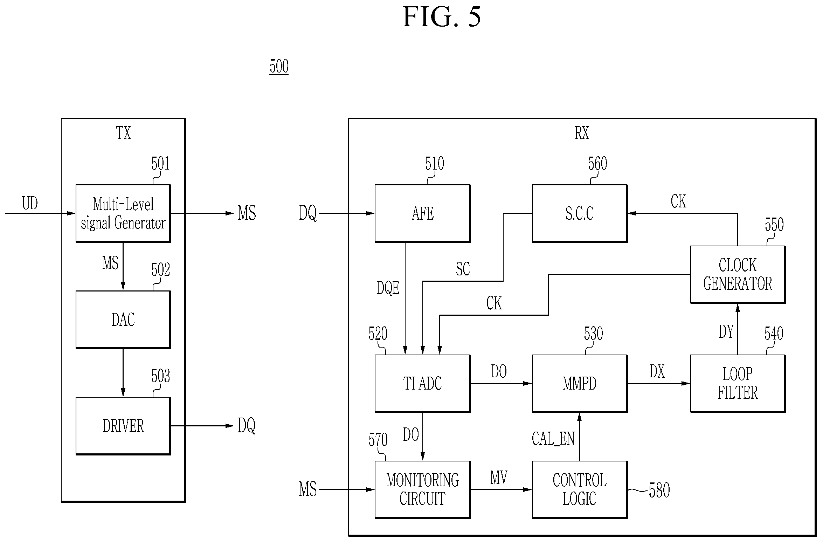

FIG. 5 illustrates a block diagram showing an example of a data transmitting/receiving system according to some implementations. In FIG. 5, a data transmitting/receiving system may include a data transmitter TX and a data receiver RX. The data transmitter TX may generate a multi-level signal MS from user data UD in a form of a digital signal. Additionally, the data transmitter TX may convert the multi-level signal MS into an analog signal to transmit it to the data receiver RX. For better understanding and ease of description, it will be assumed that the data transmitter TX is the transmitters 321a, 321b, and 321c (in FIG. 3) of the memory controller 320 (in FIG. 3), and the data receiver RX is the receivers 312a, 312b, and 312c (in FIG. 3) of the semiconductor memory device 310 (in FIG. 3).

The transmitter TX may include a multi-level signal generator 501, a digital-to-analog converter 502, and a driver 503. The multi-level signal generator 501 may receive user data UD from an external host. The multi-level signal generator 501 may generate the multi-level signal MS from the user data UD. The multi-level signal MS may have any one of N (N is a positive integer) signal levels. For example, the multi-level signal generator 501 may encode the user data UD based on PAM-4 to output one of four multi-level signals MS. The multi-level signal generator 501 may transmit the multi-level signal MS to the digital-to-analog converter 502.

The digital-to-analog converter 502 may convert the multi-level signal MS into an analog signal. The driver 503 may receive the analog signal of a multi-level signal MS converted from the digital-to-analog converter 502. The driver 503 may perform tasks necessary to transmit an analog signal of the multi-level signal MS to the receiver RX. The driver 503 may generate the data input/output signal DQ from the analog signal of the multi-level signal MS. The driver 503 may transmit the data input/output signal DQ in a form of a serial signal to the receiver RX.

The receiver RX may include an analog front end (AFE) circuit 510, a time interleaved analog-to-digital converter 520, a Mueller-Muller phase detector (MMPD) 530, a loop filter 540, a clock generator 550, a switch control signal generator (SSC) 560, a monitoring circuit 570, and control logic 580.

The analog front end circuit 510 may be a circuit positioned at an input terminal of the receiver RX to process analog signals and convert them into digital signals. The analog front end circuit 510 may amplify fine analog signals to enhance them to a level suitable for digitization. Additionally, the analog front end circuit 510 may remove noise or unwanted frequency components included in an analog signal through filtering. In this case, the analog front end circuit 510 may use a low pass filter or a band pass filter to leave only a necessary frequency band, and may refine the analog signal before transmitting it for digital signal processing.

For example, the analog front end circuit 510 may receive the data input/output signal DQ from the transmitter TX. The analog front end circuit 510 may amplify the data input/output signal DQ to enhance it to a level suitable for digitization. The analog front end circuit 510 may remove noise or unwanted frequency components included in the data input/output signal DQ by using a low-pass filter. The analog front end circuit 510 may amplify the data input/output signal DQ and remove noise to generate a processing signal DQE. The analog front end circuit 510 may transmit the processing signal DQE to the time interleaved analog-to-digital converter 520.

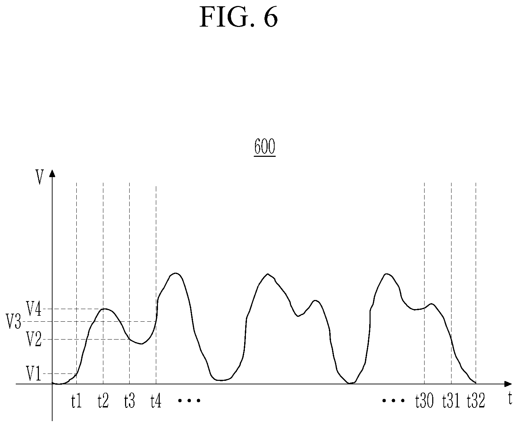

FIG. 6 illustrates a graph showing an example of a processing signal DQE according to some implementations. In FIG. 6, a voltage V of the processing signal DQE may vary with a time t from t1 to t32. For example, the voltage V of the processing signal DQE from 0 to t1 may increase from 0 V to V1 V. From t1 to t2, the voltage V of the processing signal DQE may increase from V1 V to V4 V. From t2 to t3, the voltage V of the processing signal DQE may drop from V4 V to V2 V. From t3 to t4, the voltage V of the processing signal DQE may increase from V2 V to V3 V.

In FIG. 5, a time interleaved analog-to-digital converter 520 may include multiple analog-to-digital converters (hereinafter referred to as "ADC's") arranged in parallel for digitizing a high-speed analog signal. Each of the ADC's may generate a digital signal by sampling an input analog signal at specific time intervals. With a single ADC, an input analog signal is sampled sequentially, but with multiple ADC's, an input analog signal may be sampled together at specific time intervals. Accordingly, as a number of ADC's increases, a sampling rate of the input analog signal may be improved.

For example, the time interleaved analog-to-digital converter 520 may include 32 ADC's. The time interleaved analog-to-digital converter 520 may receive the processing signal DQE from the analog front end circuit 510. The time interleaved analog-to-digital converter 520 may generate a digital signal by sampling the processing signal DQE at 32 different time intervals.

The time interleaved analog-to-digital converter 520 may receive multiple clock signals CK from the clock generator 550. The time interleaved analog-to-digital converter 520 may sample the processing signal DQE based on the clock signals CK. The time interleaved analog-to-digital converter 520 may convert the processing signal DQE into a digital data signal DO. The time interleaved analog-to-digital converter 520 may transmit the digital data signal DO to the Mueller-Muller phase detector 530. The time interleaved analog-to-digital converter 520 may transmit the digital data signal DO to the monitoring circuit 570.

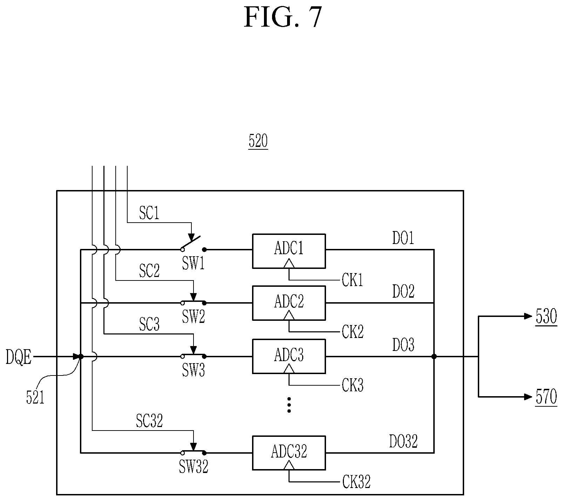

FIG. 7 illustrates a circuit diagram of an example of a time interleaved analog-to-digital converter according to some implementations.

The time interleaved analog-to-digital converter 520 (in FIG. 5) may include 32 ADC's (ADC1, ADC2, ADC3, ..., and ADC32), and each of the ADC's (ADC1, ADC2, ADC3, ..., and ADC32) may sample the processing signal DQE at 32 different time intervals using switches SW1, SW2, SW3, ..., and SW32. In this case, the switches SW1, SW2, SW3, ..., and SW32 may be connected between an input terminal 521 into which a DQE signal 600 is input and the ADC's (ADC1, ADC2, ADC3, ..., and ADC32). Each of the switches SW1, SW2, SW3, ..., and SW32 may receive switch control signals SC1, SC2, SC3, ..., and SC32 from the switch control signal generator 560 (in FIG. 5), and may be turned on (Close) or turned off (Open) based on the switch control signals SC1, SC2, SC3, ..., and SC32.

The switches SW1, SW2, SW3, ..., and SW32 may be turned on sequentially at two different timings. For example, during a period t0 to t1, only the first switch SW1 may be turned on, and during a period t1 to t2, only the second switch SW2 may be turned on. Similarly, during a period t2 to t3, only the third switch SW3 may be turned on, and during a period t31 to t32, only the 32^{nd} switch SW32 may be turned on.

During the period 0 to t1, the processing signal DQE may be transmitted to the first ADC ADC1 through the activated first switch SW1. The first ADC ADC1 may sample the processing signal DQE at a rising edge of the first clock CK1, and may convert the processing signal DQE into first digital data DO1. During the period t1 to t2, the processing signal DQE may be transmitted to the second ADC ADC2 through the activated second switch SW2. The second ADC ADC2 may sample the processing signal DQE at a rising edge of the second clock CK2, and may convert the processing signal DQE into second digital data DO2. During the period t2 to t3, the processing signal DQE may be transmitted to the third ADC ADC3 through the activated third switch SW3. The third ADC ADC3 may sample the processing signal DQE at a rising edge of the third clock CK3, and may convert the processing signal DQE into third digital data DO3. Similarly, during a period t31 to t32, the processing signal DQE may be transmitted to the 32^{nd} ADC ADC32 through the activated 32^{nd} switch SW32. The 32^{nd} ADC ADC32 may sample the processing signal DQE at a rising edge of the 32^{nd} clock CK32, and may convert the processing signal DQE into 32^{nd} digital data DO32. In this case, the first to 32^{nd} clocks CK1 to CK32 may be received by the time interleaved analog-to-digital converter 520 from the clock generator 550 (in FIG. 5). The first to 32^{nd} digital data DO1 to DO32 converted through the ADC's (ADC1, ADC2, ADC3, ..., and ADC32) may be transmitted to the Mueller-Muller phase detector 530 (in FIG. 5). The first to 32^{nd} digital data DO1 to DO32 converted through the ADC's (ADC1, ADC2, ADC3, ..., and ADC32) may be transmitted to the monitoring circuit 570 (in FIG. 5).

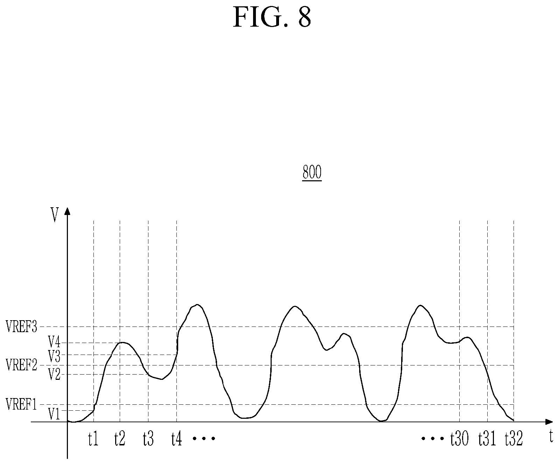

FIG. 8 illustrates a graph showing an example of a process in which a processing signal is converted into digital data through an analog-to-digital converter according to some implementations.

The ADC's (ADC1, ADC2, ADC3, ..., and ADC32 in FIG. 7) may convert the processing signal DQE into the digital data signal DO based on a first reference voltage VREF1, a second reference voltage VREF2, and a third reference voltage VREF3. For example, if the voltage of the processing signal DQE is less than the first reference voltage VREF1, the processing signal DQE may be converted to 00(2), which is the digital data signal DO. If a voltage of the processing signal DQE is greater than or equal to the first reference voltage VREF1 and less than the second reference voltage VREF2, the processing signal DQE may be converted into 01(2), which is the digital data signal DO. If the voltage of the processing signal DQE is greater than or equal to the second reference voltage VREF2 and less than the third reference voltage VREF3, the processing signal DQE may be converted into 10(2), which is the digital data signal DO. If the voltage of the processing signal DQE is greater than or equal to the third reference voltage VREF3, the processing signal DQE may be converted to 11(2), which is the digital data signal DO.

For example, a voltage V1 of the processing signal DQE at t1 is less than the first reference voltage VREF 1, the processing signal DQE from 0 to t1 may be converted into 00(2), which is the digital data signal DO. A voltage V4 of the processing signal DQE at t2 is greater than or equal to the second reference voltage VREF2 and less than the third reference voltage VREF3, so the processing signal DQE from t1 to t2 may be converted into 10(2), which is the digital data signal DO. A voltage V2 of the processing signal DQE at t3 is greater than or equal to the first reference voltage VREF1 and less than the second reference voltage VREF2, so the processing signal DQE from t2 to t3 may be converted into 01(2), which is the digital data signal DO. A voltage V3 of the processing signal DQE at t4 is greater than or equal to the second reference voltage VREF2 and less than the third reference voltage VREF3, so the processing signal DQE from t3 to t4 may be converted into 10(2), which is the digital data signal DO. Accordingly, the first ADC ADC1 may output 00(2) as the first digital data DO1, and the second ADC ADC2 may output 10(2) as the second digital data DO2. The third ADC ADC3 may output 01(2) as the third digital data DO3, and the fourth ADC ADC4 may output 10(2) as the fourth digital data DO4. In the same manner as above, the remaining ADC's ADC5 to ADC32 may also output digital data DO5 to DO32.

In FIG. 5, the Mueller-Muller phase detector 530 may detect sampling timing errors of the digital data signal DO. The Mueller-Muller phase detector 530 may receive a continuous digital data signal DO from the time interleaved analog-to-digital converter 520. The Mueller-Muller phase detector 530 may detect sampling timing errors by calculating a difference between consecutive digital data signals DO. The Mueller-Muller phase detector 530 may transmit a sampling control signal DX, which is a control signal for correcting an error in sampling timing, to the loop filter 540.

In some implementations, the Mueller-Muller phase detector 530 may receive a digital data signal DO, and may determine whether the digital data signal DO is phase-delayed or phase-advanced. The Mueller-Muller phase detector 530 may determine whether the digital data signal DO is phase-delayed or phase-advanced based on two digital data signals DO. For example, the Mueller-Muller phase detector 530 may determine whether the digital data signal DO is phase-delayed or phase-advanced based on the digital data signal DO converted at adjacent timings. The Mueller-Muller phase detector 530 may also detect sampling timing errors based on whether the digital data signal DO is phase-delayed or phase-advanced.

The loop filter 540 (e.g., a digital loop filter) may integrate a sampling control signal DX, which is an output of a Mueller-Muller phase detector 530. The loop filter 540 may generate a phase adjustment signal DY by integrating the sampling control signal DX. The loop filter 540 may transmit the phase adjustment signal DY to the clock generator 550.

The clock generator 550 may output the clock signal CK whose frequency and phase are adjusted based on the phase adjustment signal DY, which is an output of a loop filter. The clock generator 550 may transmit the clock signal CK to the time interleaved analog-to-digital converter 520 and the switch control signal generator 560.

The switch control signal generator 560 may generate a switch control signal SC based on the clock signal CK. The switch control signal generator 560 may transmit the switch control signal SC to the time interleaved analog-to-digital converter 520.

The monitoring circuit 570 may receive the digital data signal DO from the time interleaved analog-to-digital converter 520. The monitoring circuit 570 may receive a multi-level signal MS from the multi-level signal generator 501. The monitoring circuit 570 may generate a monitoring output signal MV based on a difference between the digital data signal DO and the multi-level signal MS. The monitoring circuit 570 may transmit the monitoring output signal MV to the control logic 580.

The monitoring circuit 570 may calculate a bit error rate based on the digital data signal DO and the multi-level signal MS. The monitoring circuit 570 may calculate a bit error rate (BER) based on a total number of transmission bits of the multi-level signal MS transmitted from the transmitter TX and a number of error bits between the multi-level signal MS and the digital data signal DO. The monitoring circuit 570 may transmit the calculated bit error rate (BER) as the monitoring output signal MV to the control logic 580.

The monitoring circuit 570 may calculate a signal-to-noise ratio based on the digital data signal DO and the multi-level signal MS. The monitoring circuit 570 may calculate the signal-to-noise ratio (SNR) based on a signal power of the multi-level signal MS, a signal power of the digital data signal DO, and a noise power.

The monitoring circuit 570 may utilize the signal power of the digital data signal DO or the signal power of the multi-level signal MS in calculating the signal-to-noise ratio (SNR). The multi-level signal MS and the digital data signal DO, which are PAM 4 signals, may have four types of voltage levels, so the signal power may be calculated through a square average of each voltage level value.

Noise electric power may include power loss due to power line interference occurring along a transmission path. The noise electric power may include power losses due to thermal noise and white noise occurring in the transmission path.

The monitoring circuit 570 may transmit the calculated signal-to-noise ratio (SNR) as the monitoring output signal MV to the control logic 580. For example, if an average power of the multi-level signal MS is 100 W and power loss is 1 W, the signal-to-noise ratio (SNR) may be 100. The monitoring circuit 570 may transmit a signal-to-noise ratio (SNR) of 100 to the control logic 580 as the monitoring output signal MV. If an average power of the digital data signal DO is 500W and power loss is 1 W, the signal-to-noise ratio (SNR) may be 50. The monitoring circuit 570 may transmit the calculated signal-to-noise ratio (SNR) of 50 to the control logic 580 as the monitoring output signal MV.

The control logic 580 may receive the monitoring output signal MV from the monitoring circuit 570. The control logic 580 may generate an operator selection signal CAL_EN based on the monitoring output signal MV. The control logic 580 may transmit the operator selection signal CAL_EN to the Mueller-Muller phase detector 530.

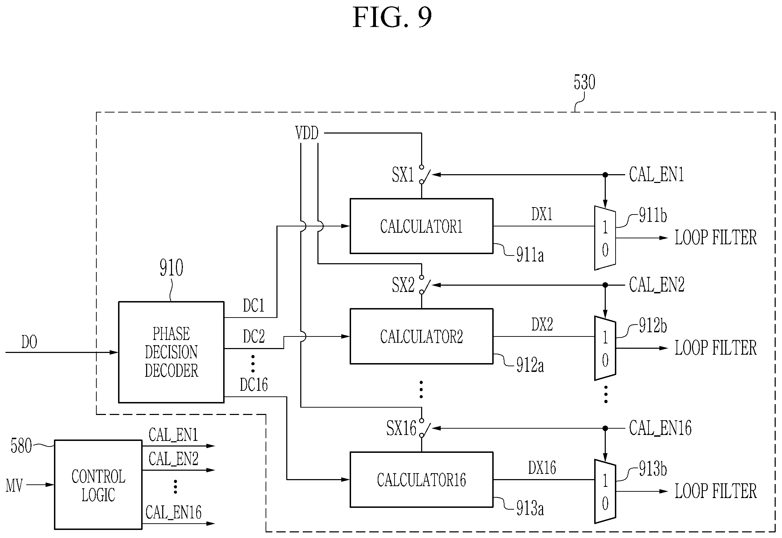

FIG. 9 illustrates a block diagram showing an example of a portion of a configuration of a Mueller-Muller phase detector according to some implementations.

The Mueller-Muller phase detector 530 may include a phase decision decoder 910, a plurality of calculators 911a, 912a, ..., and 913a, and a plurality of multiplexers 911b, 912b, ..., and 913b.

The phase decision decoder 910 may receive the digital data signal DO from the time interleaved analog-to-digital converter 520 (in FIG. 5). The phase decision decoder 910 may generate transition information of the digital data signal DO based on a continuously input digital data signal DO(N-1) and the digital data signal DO, and may determine whether a phase of the digital data signal DO is leading or lagging.

The phase decision decoder 910 may select one of a plurality of calculators 911a, 912a, ..., and 913a based on transition information of the digital data signal DO. The phase decision decoder 910 may output phase decision signals DC1, DC2, ..., and DC16 to the selected calculators 911a, 912a, ..., and 913a. The phase decision signals DC1, DC2, ..., and DC16 may include a value of the continuously input digital data signal DO(N-1), a value of the digital data signal DO, and phase information.

For example, if the digital data signal DO(N-1) is 11(2) and the digital data signal DO(N) is 11(2) and is identical to the digital data signal DO(N-1), the phase decision decoder 910 may select the first calculator 911a. If the digital data signal (DO(N-1)) is 10(2) and the digital data signal (DO(N)) is 11(2), the phase decision decoder 910 may select the second calculator 912a. If the digital data signal (DO(N-1)) is 00(2) and the digital data signal (DO(N)) is 00(2), the phase decision decoder 910 may select the 16^{th} calculator 913a. However, the present disclosure is not limited to this example.

The phase decision decoder 910 may select one of the calculators 911a, 912a, ..., and 913a by considering transition information and phase information of the digital data signal DO. For example, if the digital data signal DO is phase-advanced with respect to the clock signal CK and the digital data signal DO transitions from 11(2) to 11(2), the phase decision decoder 910 may output the phase decision signal DC1 to the first calculator 911a (in FIG. 9). If the digital data signal DO is phase-advanced with respect to the clock signal CK and the digital data signal DO transitions from 10(2) to 11(2), the phase decision decoder 910 may output the phase decision signal DC2 to the second calculator 912a (in FIG. 9). If the digital data signal DO is phase-advanced with respect to the clock signal CK and the digital data signal DO transitions from 00(2) to 00(2), the phase decision decoder 910 may output the phase decision signal DC16 to the 16^{th} calculator 913a (in FIG. 9). If the digital data signal DO is phase-delayed with respect to the clock signal CK and transitions from 00(2) to 00(2), the phase decision decoder 910 may output the phase decision signal DC1 to the first calculator 911a. If the digital data signal DO is phase-delayed with respect to the clock signal CK and transitions from 10(2) to 11(2), the phase decision decoder 910 may output the phase decision signal DC2 to the second calculator 912a. If the digital data signal DO is phase-delayed with respect to the clock signal CK and transitions from 11(2) to 11(2), the phase decision decoder 910 may output the phase decision signal DC16 to the 16^{th} calculator 913a. A method by which the phase decision decoder 910 outputs the phase decision signals DC1 to DC16 to the calculators 911a, 912a, and 913a based on phase information and transition information is not limited thereto.

Each of the calculators 911a, 912a, ..., and 913a may perform an operation corresponding to a different transition among a plurality of transitions that can occur between the digital data signal DO(N) and the digital data signal DO(N-1). The calculators 911a, 912a, ..., and 913a may receive phase decision signals DC1, DC2, ..., and DC16, and may generate sampling control signals DX1, DX2, ..., and DX16 that control timing of a plurality of clock signals based on the phase decision signals DC1, DC2, ..., and DC16. Accordingly, interference between the calculators 911a, 912a, ..., and 913a may be minimized, and a calculation processing speed may be improved.

Each of the calculators 911a, 912a, ..., and 913a may receive a driving voltage from a separate voltage source VDD. Switches SX1, SX2, ..., and SX16 may be connected between the calculators 911a, 912a, ..., and 913a and the voltage source VDD. Each of the calculators 911a, 912a, ..., and 913a may receive the driving voltage from the voltage source VDD while the switches SX1, SX2, ..., and SX16 are turned on.

Each of the switches SX1, SX2, ..., and SX16 may receive a calculator selection signal CAL_EN from the control logic 580. The switches SX1, SX2, ..., and SX16 may be turned on or off based on the calculator selection signal CAL _EN. For example, the first switch SX1 may be turned on or off based on a first calculator selection signal CAL_EN1. The second switch SX2 may be turned on or off based on a second calculator selection signal CAL_EN2. The 16^{th} switch SX16 may be turned on or off based on a 16^{th} calculator selection signal CAL_EN16. As a number of the calculators 911a, 912a, ..., and 913a that are driven by applying a driving voltage decreases among the calculators 911a, 912a, ..., and 913a, power consumption generated in the Mueller-Muller phase detector 530 (in FIG. 5) may be reduced.

The calculator selection signals CAL_EN1, CAL_EN2, ..., and CAL_EN16 may be generated by the control logic 580. The control logic 580 may generate the calculator selection signals CAL_EN1, CAL_EN2, ..., and CAL _EN16 that control switches SX1, SX2, ..., and SX16 connected to the calculators 911a, 912a, ..., and 913a determined based on the transition information of the digital data signal DO.

The control logic 580 may generate the calculator selection signals CAL_EN1, CAL_EN2, ..., and CAL_EN16 that turn on or off the switches SX1, SX2, ..., and SX16 based on the monitoring output signal MV. The control logic 580 may transmit the calculator selection signals CAL_EN1, CAL_EN2, ..., and CAL_EN16 to the switches SX1, SX2, ..., and SX16. The switches SX1, SX2, ..., and SX16 may be turned on or off based on the calculator selection signals CAL_EN1, CAL_EN2, ..., and CAL_EN16. The control logic 580 may control whether the switches SX1, SX2, ..., and SX16 may be enabled based on the monitoring output signal MV. For example, the control logic 580 may enable a number of switches required to satisfy a reference value based on the monitoring output signal MV and disable the remaining switches. For example, the control logic 580 may enable six of the 16 switches SX1, SX2, ..., and SX16 and disable ten of the switches. The control logic 580 may generate the calculator selection signals CAL_EN1, CAL_EN2, ..., and CAL_EN16 to enable seven switches and disable nine switches based on the monitoring output signal MV that does not satisfy the reference value. In some implementations, the control logic 580 may generate the calculator selection signals CAL_EN1, CAL_EN2, ..., and CAL_EN16 to enable five switches and disable eleven switches based on the monitoring output signal MV that satisfies the reference value.

The control logic 580 may generate the calculator selection signals CAL_EN1, CAL_EN2, ..., and CAL_EN16 that turn on the switches SX1, SX2, ..., and SX16 connected to the calculators 911a, 912a, ..., and 913a determined based on the transition information of the digital data signal DO when the bit error rate (BER) between the digital data signal DO and the multi-level signal MS is equal to or greater than a first reference value. The control logic 580 may generate the calculator selection signals CAL_EN1, CAL_EN2, ..., and CAL_EN16 that turn off the switches SX1, SX2, ..., and SX16 connected to the calculators 911a, 912a, ..., and 913a determined based on the transition information of the digital data signal DO when the bit error rate (BER) between the digital data signal DO and the multi-level signal MS is less than a first reference value. In this case, a value corresponding to the first reference value may be stored in a separate storage device within the control logic.

For example, when the bit error rate (BER) between the digital data signal DO and the multi-level signal MS is 10⁻⁴ and the first reference value is 5, the control logic 580 may generate the calculator selection signals CAL_EN1, CAL_EN2, ..., and CAL_EN16 that turns off the switches SX1, SX2, ..., and SX16 connected to the calculators 911a, 912a, ..., and 913a determined based on the transition information of the digital data signal DO. When the bit error rate (BER) between the digital data signal DO and the multi-level signal MS is 3⁻⁴ and the first reference value is 5⁻⁴, the control logic 580 may generate the calculator selection signals CAL_EN1, CAL_EN2, ..., and CAL_EN16 that turns on the switches SX1, SX2, ..., and SX16 connected to the calculators 911a, 912a, ..., and 913a determined based on the transition information of the digital data signal DO.

The control logic 580 may generate the calculator selection signals CAL_EN1, CAL_EN2, ..., and CAL_EN16 that turn on the switches SX1, SX2, ..., and SX16 connected to the calculators 911a, 912a, ..., and 913a determined based on the transition information of the digital data signal DO when the signal-to-noise ratio of the digital data signal DO or the multi-level signal MS is less than the first reference value. The control logic 580 may generate the calculator selection signals CAL_EN1, CAL_EN2, ..., and CAL_EN16 that turn off the switches SX1, SX2, ..., and SX16 connected to the calculators 911a, 912a, ..., and 913a determined based on the transition information of the digital data signal DO when the signal-to-noise ratios of the digital data signal DO and the multi-level signal MS are greater than or equal to the first reference value.

For example, when the signal-to-noise ratio SNR is 100 and the first reference value is 50, the control logic 580 may generate the calculator selection signals CAL_EN1, CAL_EN2, ..., and CAL_EN16 that turns off the switches SX1, SX2, ..., and SX16 connected to the calculators 911a, 912a, ..., and 913a determined based on the transition information of the digital data signal DO. When the signal-to-noise ratio SNR is 40 and the first reference value is 50, the control logic 580 may generate the calculator selection signals CAL_EN1, CAL_EN2, ..., and CAL_EN16 that turns on the switches SX1, SX2, ..., and SX16 connected to the calculators 911a, 912a, ..., and 913a determined based on the transition information of the digital data signal DO.

The sampling control signals DX1, DX2, ..., DX16, which are calculation values output from the respective calculators 911a, 912a, ..., and 913a, may be input to multiplexers 911b, 912b, ..., and 913b (in FIG. 9). The control logic 580 may transmit the first calculator selection signal CAL_EN1, the second calculator selection signal CAL_EN2, and the sixteenth calculator selection signal CAL_EN16 to the first multiplexer 911b, the second multiplexer 912b, and the sixteenth multiplexer 913b, respectively. The multiplexers 911b, 912b, ..., and 913b may receive the respective calculator selection signals CAL_EN from the control logic 580, and may determine processing for sampling the control signals DX1, DX2, ..., and DX16 based on the respective calculator selection signals CAL_EN.

The multiplexers 911b, 912b, ..., and 913b may receive the sampling control signals DX1, DX2, ..., and DX16 from the calculators 911a, 912a, ..., and 913a, and may selectively output sampling control signals DX1, DX2, ..., and DX16. The multiplexers 911b, 912b, ..., and 913b may receive the sampling control signals DX1, DX2, ..., and DX16 received from the calculators 911a, 912a, ..., and 913a based on the calculator selection signals CAL_EN, and transmit them as is to the loop filter 540 (in FIG. 5). The multiplexer 911b, 912b, ..., and 913b may not transfer the sampling control signals DX1, DX2, ..., and DX16 to the loop filter 540 based on the calculator selection signals CAL_EN.

When the switch SX1, SX2, ..., and SX16 connected to one of the calculators 911a, 912a, ..., and 913a is turned on based on the calculator selection signals CAL_EN, one of the multiplexers 911b, 912b, ..., and 913b receiving the output of the calculators 911a, 912a, ..., and 913a may transfer the sampling control signals DX1, DX2, ..., and DX16 received from the calculators 911a, 912a, ..., and 913a to the loop filter 540 (in FIG. 5).

When the switch SX1, SX2, ..., and SX16 connected to one of the calculators 911a, 912a, ..., and 913a is turned off based on the calculator selection signals CAL_EN, one of the multiplexers 911b, 912b, ..., and 913b receiving the output of the calculators 911a, 912a, ..., and 913a may not transfer the sampling control signals DX1, DX2, ..., and DX16 received from the calculators 911a, 912a, ..., and 913a to the loop filter 540.

For example, the control logic 580 may transmit the first calculator selection signal CAL_EN1, the second calculator selection signal CAL_EN2, and the sixteenth calculator selection signal CAL_EN16 for activating the first calculator 911a, the second calculator 912a, and the sixteenth calculator 913a to the first multiplexer 911b, the second multiplexer 912b, and the sixteenth multiplexer 913b. The first multiplexer 911b, the second multiplexer 912b, and the sixteenth multiplexer 913b may receive the sampling control signals DX1, DX2, and DX16 from the first calculator 911a, the second calculator 912a, and the sixteenth calculator 913a, respectively. The first multiplexer 911b, the second multiplexer 912b, and the sixteenth multiplexer 913b may each transfer the sampling control signals DX1, DX2, and DX16 to the loop filter 540. The remaining multiplexers, except for the first multiplexer 911b, the second multiplexer 912b, and the 16^{th} multiplexer 913b, may not transfer the received sampling control signals DX to the loop filter 540.

The phase decision decoder 910 may output phase decision signals DC1, DC2, ..., and DC16 to the selected calculators 911a, 912a, ..., and 913a. The phase decision decoder 910 may generate transition information of two digital data DO(N) and DO(N-1), and may determine phase information for sampling timing of the two digital data DO(N) and DO(N-1). The phase decision decoder 910 may generate the phase decision signals DC1, DC2, ..., and DC16 (in FIG. 9) including phase information.

The phase decision decoder 910 may output phase decision signals DC1, DC2, ..., DC16 to the calculators 911a, 912a, ..., and 913a based on the transition and phase information between the digital data signal DO(N) and the digital data signal DO(N-1).

For example, if the digital data signal DO is phase-advanced with respect to the clock signal CK and the digital data signal DO transitions from 11(2) to 11(2), the phase decision decoder 910 may output the phase decision signal DC1 to the first calculator 911a. If the digital data signal DO is phase-advanced with respect to the clock signal CK and the digital data signal DO transitions from 10(2) to 11(2), the phase decision decoder 910 may output the phase decision signal DC2 to the second calculator 912a. If the digital data signal DO is phase-advanced with respect to the clock signal CK and the digital data signal DO transitions from 00(2) to 00(2), the phase decision decoder 910 may output the phase decision signal DC16 to the 16^{th} calculator 913a. If the digital data signal DO is phase-delayed with respect to the clock signal CK and transitions from 00(2) to 00(2), the phase decision decoder 910 may output the phase decision signal DC1 to the first calculator 911a. If the digital data signal DO is phase-delayed with respect to the clock signal CK and transitions from 10(2) to 11(2), the phase decision decoder 910 may output the phase decision signal DC2 to the second calculator 912a. If the digital data signal DO is phase-delayed with respect to the clock signal CK and transitions from 11(2) to 11(2), the phase decision decoder 910 may output the phase decision signal DC16 to the 16^{th} calculator 913a. However, a method by which the phase decision decoder 910 outputs the phase decision signals DC1 to DC16 to the calculators 911a, 912a, and 913a based on phase information and transition information is not limited thereto.

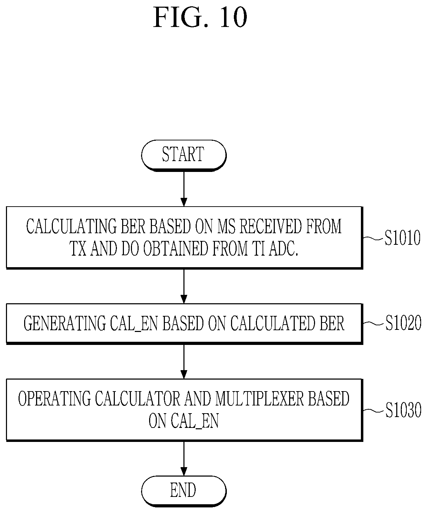

FIG. 10 illustrates a flowchart showing an example of a process in which an operator and a multiplexer are driven by an operator selection signal according to some implementations. In step S1010, the receiver RX (in FIG. 5) may calculate a bit error rate (BER) based on the multi-level signal MS (in FIG. 5) received from the transmitter TX (in FIG. 5) and the digital data signal DO (in FIG. 5) obtained from the time interleaved analog-to-digital converter 520 (in FIG. 5). The receiver RX may calculate a bit error rate (BER) based on a total number of transmission bits of the multi-level signal MS transmitted from the transmitter TX and a number of error bits between the multi-level signal MS and the digital data signal DO. A number of error bits may refer to a number of bits that are different between the multi-level signal MS and the digital data signal DO. For example, when a total number of transmission bits of the multi-level signal MS is 10⁴ and the number of error bits is 1, the bit error rate (BER) be 10⁻⁴.

In step (S1020), the receiver RX may generate the calculator selection signal CAL_EN (in FIG. 9) based on the calculated bit error rate (BER). The receiver RX may obtain a first reference value from a separate storage device included in the receiver RX for comparison of bit error rate (BER). The receiver RX may generate the calculator selection signals CAL_EN1, CAL_EN2, ..., and CAL_EN16 that turns on the switches SX1, SX2, ..., and SX16 connected to the calculators 911a, 912a, ..., and 913a determined based on transition information of the digital data signal DO when the bit error rate (BER) is greater than or equal to the first threshold. The receiver RX may generate the calculator selection signals CAL_EN1, CAL_EN2, ..., and CAL_EN16 that turns off the switches SX1, SX2, ..., and SX16 connected to the calculators 911a, 912a, ..., and 913a (in FIG. 9) determined based on transition information of the digital data signal DO when the bit error rate (BER) is less than the first threshold.

In step (S1030), the calculators 911a, 912a, ..., and 913a and the multiplexers 911b, 912b, ..., 913b (in FIG. 9) may be driven based on the calculator selection signals CAL_EN1, CAL_EN2, ..., and CAL_EN16. The switches SX1, SX2, ..., and SX16 may be turned on based on the calculator selection signals CAL_EN1, CAL_EN2, ..., and CAL_EN16 that turn on the switches SX1, SX2, ..., and SX16. A driving voltage may be applied to the calculators 911a, 912a, ..., and 913a. The multiplexers 911b, 912b, ..., and 913b may receive the sampling control signals DX1, DX2, ..., DX16, which are calculation values output from each of the calculators 911a, 912a, ..., and 913a. The multiplexers 911b, 912b, ..., and 913b may receive the sampling control signals DX1, DX2, ..., and DX16, and may transfer them as is to the loop filter 540 (in FIG. 5).

The switches SX1, SX2, ..., and SX16 may be turned off based on the calculator selection signals CAL_EN1, CAL_EN2, ..., and CAL_EN16 that turn off the switches SX1, SX2, ..., and SX16. A driving voltage may not be applied to the calculators 911a, 912a, ..., and 913a. The multiplexers 911b, 912b, ..., and 913b may not transfer the sampling control signals DX1, DX2, ..., and DX16, which are calculation values output from each of the calculators 911a, 912a, ..., and 913a, to the loop filter 540.

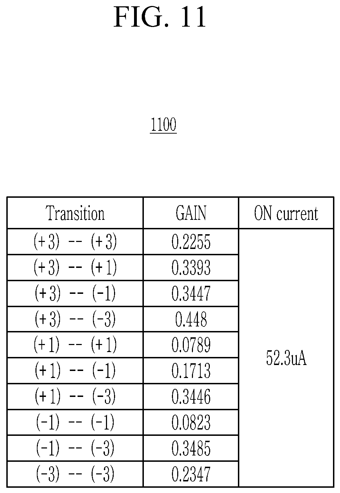

FIG. 11 illustrates a table showing examples of gain and current consumption generated in a Mueller-Muller phase detector based on transition of digital data according to some implementations. In FIG. 11, gain may indicate variability of an output result value depending on a phase difference between the digital data signal DO and the clock signal CK input to the Mueller-Muller phase detector 530 (in FIG. 5). As the gain increases, the variability of the result value increases, making it easier to adjust the phase of the clock signal CK to accurately capture the digital data signal DO. Additionally, as the gain increases, a gain noise ratio (GNR) improves, so distortion caused by noise in the digital data signal DO and the clock signal CK may be eliminated.

The gain may vary depending on a voltage level difference between two consecutively input digital data signals DO. For example, the gain of the Mueller-Muller phase detector 530 in a transition from +3 V to +3 V may be 0.2255 V/rad, the gain of the Mueller-Muller phase detector 530 in a transition from +3 V to +1 V may be 0.3393 V/rad, and the gain of the Mueller-Muller phase detector 530 in a transition from +3 V to -1 V may be 0.3447 V/rad. The gain of the Mueller-Muller phase detector 530 in a transition from +3 V to -3 V may be 0.448 V/rad, the gain of the Mueller-Muller phase detector 530 in a transition from +1 V to +1 V may be 0.0789 V/rad, and the gain of the Mueller-Muller phase detector 530 in a transition from +1 V to -1 V may be 0.1713 V/rad. The gain of the Mueller-Muller phase detector 530 at a transition from +1 V to -3 V may be 0.3446 V/rad, at a transition from -1 V to -1 V, the gain of the Mueller-Muller phase detector 530 may be 0.0823 V/rad, at a transition from -1 V to -3 V, the gain of the Mueller-Muller phase detector 530 may be 0.3485 V/rad, and at a transition from -3 V to -3 V, the gain of the Mueller-Muller phase detector 530 may be 0.2347 V/rad.

If the Mueller-Muller phase detector 530 detects all transitions occurring in the digital data signal DO, the gain may increase, but current consumption may also increase. The current consumption generated by the Mueller-Muller phase detector 530 that detects all transitions may be 52.3 µA each.

The Mueller-Muller phase detector 530 may select at least one type of transition, and may detect only the selected transition in the digital data signal DO. The calculators 911a, 912a, and 913a (in FIG. 9) corresponding to the transitions not selected by the Mueller-Muller phase detector 530 may not receive a driving voltage from the voltage source VDD (in FIG. 9) because the switches SX1, SX2, ..., and SX16 are turned off. The calculators 911a, 912a, and 913a are not driven, so current consumption generated in the Mueller-Muller phase detector 530 may be reduced. Accordingly, the fewer transitions the Mueller-Muller phase detector 530 selects, the fewer a number of driven calculators 911a, 912a, and 913a may be required, allowing the Mueller-Muller phase detector 530 to be driven at lower power.

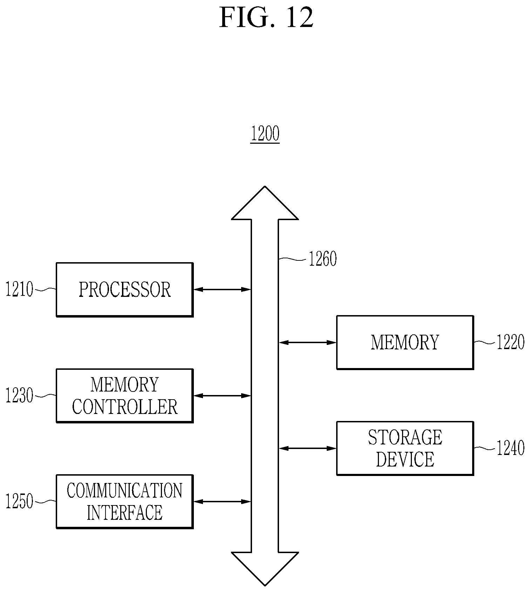

FIG. 12 illustrates an example block diagram showing an example of a computer device according to some implementations. In FIG. 12, a computing device 1200 includes a processor 1210, a memory 1220, a memory controller 1230, a storage device 1240, a communication interface 1250, and a bus 1260. The computing device 1200 may further include other general-purpose components.

The processor 1210 controls an overall operation of each component of the computing device 1200. The processor 1210 may be implemented as at least one of various processing units such as a central processing unit (CPU), an application processor (AP), and a graphics processing unit (GPU).

The processor 1210 may obtain transition information based on two digital data DO (of FIG. 5), and may determine whether the digital data signal DO is phase-delayed or phase-advanced. The processor 1210 may detect a sampling timing error of the digital data signal DO based on the transition information and the phase information.

The processor 1210 may compute the bit error rate (BER). The processor 1210 may calculate the bit error rate (BER) based on the multi-level signal MS (in FIG. 5) and the digital data signal DO. The processor 1210 may compare the computed bit error rate (BER) with a first reference value, and may generate calculator selection signals CAL_EN1, CAL_EN2, ..., and CAL_EN16 (in FIG. 9) that drives the calculators 911a, 912a, ..., and 913a (in FIG. 9) and the multiplexers 911b, 912b, ..., and 913b (in FIG. 9).

The memory 1220 stores various data and commands. The memory 1220 may be implemented as a memory device described with reference to FIG. 1 to FIG. 11. The memory controller 1230 controls the transfer of data or commands to and from the memory 1220. In some implementations, the memory controller 1230 may be provided as a separate chip from the processor 1210. In some implementations, the memory controller 1230 may be provided as an internal component of the processor 1210.

The storage device 1240 non-temporarily stores programs and data. In some implementations, the storage device 1240 may be implemented as a non-volatile memory. The communication interface 1250 supports wired and wireless Internet communication of the computing device 1200. In addition, the communication interface 1250 may support various communication methods other than Internet communication. The bus 1260 provides communication functionality between components of computing device 1200. The bus 1260 may include at least one type of bus depending on communication protocol between components.

## Claims

1. A receiver (RX) comprising:
an analog front end circuit (510) configured to receive a data input/output signal (DQ), and amplify the data input/output signal (DQ) to generate a processing signal (DQE);
a time interleaved analog-to-digital converter, TI ADC (520), configured to sample the processing signal (DQE) based on a plurality of clock signals (CK) and generate a plurality of digital data signals (DO);
a Mueller-Muller phase detector (530) configured to receive the plurality of digital data signals (DO) from the TI ADC (520) and drive at least one calculator (911a) of a plurality of calculators (911a-913a) based on a transition between two digital data signals (DO) received sequentially among the plurality of digital data signals (DO);
a monitoring circuit (570) configured to receive the plurality of digital data signals (DO) from the TI ADC (520), receive a multi-level signal (MS) transmitted from a transmitter (TX), and generate a monitoring output signal (MV) based on the plurality of digital data signals (DO) and the multi-level signal (MS); and
a control logic circuit (580) configured to receive a monitoring output signal (MV) output from the monitoring circuit (570) and generate a plurality of calculator selection signals (CAL_EN1-CAL_EN16) that are configured to drive the plurality of calculators (911a-913a) based on the monitoring output signal (MV).

2. The receiver (RX) of claim 1, wherein the Mueller-Muller phase detector (530) includes:
a phase decision decoder circuit (910) configured to generate transition information of the two digital data signals (DO), determine phase information for clock signals (CK) used to sample the two digital data signals (DO), and output a phase decision signal (DC1-DC16) including the phase information, wherein the phase decision signal (DC1-DC16) optionally includes the transition information and/or values of the two digital data signals (DO);
wherein the plurality of calculators (911a-913a) are configured to receive the phase decision signal (DC1-DC16) and generate a plurality of sampling control signals (DX1-DX16) used to control timing of the clock signals (CK) based on the phase decision signal (DC1-DC16);
a plurality of switches (SX1-SX16) configured to connect the plurality of calculators (911a-913a) and a voltage source (VDD); and
a plurality of multiplexers (911b-913b) configured to receive the sampling control signals (DX1-DX16) from the plurality of calculators (911a-913a) and selectively output the sampling control signals (DX1-DX16).

3. The receiver (RX) of claim 2,
wherein the phase decision decoder circuit (910) is configured to select a calculator (911a) from among the plurality of calculators (911a-913a) based on the transition information and output the phase decision signal (DC1-DC16) to the calculator (911a), and
wherein the plurality of switches (SX1-SX16) are configured to be turned on or off based on the calculator selection signals (CAL_EN1-CAL_EN16).

4. The receiver (RX) of any one of claims 1 to 3, wherein the monitoring circuit (570) is configured to:
compute a signal-to-noise ratio based on signal power measured through an average square of a voltage level value of the two digital data signals (DO) or the multi-level signal (MS) and noise power including a power loss occurring in a signal transmission path, and
generate the signal-to-noise ratio as the monitoring output signal (MV).

5. The receiver (RX) of claim 4,
wherein the control logic circuit (580) is configured to generate the plurality of calculator selection signals (CAL_EN1-CAL_EN16) configured to drive n calculators - a positive number where *n<m* - from among the plurality of calculators (911a-913a) based on the monitoring output signal (MV) that is greater than a reference value.

6. The receiver (RX) of claim 5,
wherein a group of switches (SX1-SX16) from among the plurality of switches (SX1-SX16) connected to the n calculators are configured to be turned off based on the plurality of calculator selection signals (CAL_EN1-CAL_EN16), and
wherein a group of multiplexers (911b-913b) from among the plurality of multiplexers (911b-913b) that are connected to the n calculators are configured to not transfer the sampling control signals (DX1-DX16) output from the n calculators to a loop filter (540).

7. The receiver (RX) of claim 5 or 6,
wherein the control logic circuit (580) is configured to generate the plurality of calculator selection signals (CAL_EN1-CAL_EN16) configured to drive *m* calculators - a positive number where *n<m* - from among the plurality of calculators (911a-913a) based on the monitoring output signal (MV) that is less than the reference value.

8. The receiver (RX) of claim 7,
wherein another group of switches (SX1-SX16) from among the plurality of switches (SX1-SX16) connected to the *m* calculators are configured to be turned on based on the plurality of calculator selection signals (CAL_EN1-CAL_EN16), and
wherein another group of multiplexers (911b-913b) from among the plurality of multiplexers (911b-913b) that are connected to the *m* calculators are configured to output sampling control signals (DX1-DX16) output from the *m* calculators based on the plurality of calculator selection signals (CAL_EN1-CAL_EN16).

9. The receiver (RX) of any one of claims 1 to 3, wherein the monitoring circuit (570) is configured to:
compute a bit error rate based on a total number of transmission bits of the multi-level signal (MS) transmitted from the transmitter (TX) and a number of error bits between the multi-level signal (MS) and the two digital data signals (DO), and
generate the bit error rate as the monitoring output signal (MV).

10. The receiver (RX) of claim 9,
wherein the control logic circuit (580) is configured to generate the plurality of calculator selection signals (CAL_EN1-CAL_EN16) configured to drive *m* calculators - a positive number where *n<m* - from among the plurality of calculators (911a-913a) based on the monitoring output signal (MV) that is greater than a reference value.

11. The receiver (RX) of claim 10,
wherein a group of switches (SX1-SX16) from among the plurality of switches (SX1-SX16) connected to the *m* calculators are configured to be turned on based on the plurality of calculator selection signals (CAL_EN1-CAL_EN16), and
a group of multiplexers (911b-913b) from among the plurality of multiplexers (911b-913b) connected to the *m* calculators are configured to output sampling control signals (DX1-DX16) output from the *m* calculators based on the calculator selection signals (CAL_EN1-CAL_EN16).

12. The receiver (RX) of claim 10 or 11,
wherein the control logic circuit (580) is configured generate the calculator selection signals (CAL_EN1-CAL_EN16) configured to drive *n* calculators - a positive number where *n<m* - from among the plurality of calculators (911a-913a) based on the monitoring output signal (MV) that is less than or the reference value.

13. The receiver (RX) of claim 12,
wherein another group of switches (SX1-SX16) from among the plurality of switches (SX1-SX16) connected to the *n* calculators are configured to be turned off by receiving the calculator selection signals (CAL_EN1-CAL_EN16), and
wherein another group of multiplexers (911b-913b) from among the plurality of multiplexers (911b-913b) connected to the *n* calculators are configured to not transfer the sampling control signals (DX1-DX16) output from the *n* calculators to a loop filter (540).

14. The receiver (RX) of any one of claims 9 to 13, wherein the monitoring output signal (MV) includes a signal representing a bit error rate that is determined based on a number of bit errors of the multi-level signal (MS) and the plurality of digital data signals (DO).
